# EUROPÄISCHE PATENTSCHRIFT

(11) **EP 1 258 063 B1**
(45) Veröffentlichungstag und Bekanntmachung des Hinweises auf die Patenterteilung: **29.10.2003**
(21) Anmeldenummer: 00982965.6
(22) Anmeldetag: 28.09.2000
(51) Int. Cl.: H01S 5/068, H01S 5/0683, H01S 5/40

(54) **REGELVORRICHTUNG FÜR LASERDIODEN**
DEVICE FOR ADJUSTING LASER DIODES
DISPOSITIF DE REGULATION POUR DIODES LASER

(30) Priorität: 30.09.1999 DE 19948689
(43) Veröffentlichungstag der Anmeldung: 20.11.2002
(73) Patentinhaber: Infineon Technologies AG, 81669 München (DE)
(72) Erfinder: SCHRÖDINGER, Karl, 14089 Berlin (DE); OHEIM, Toralf, 16763 Hennigsdorf (DE)
(74) Vertreter: Müller, Wolfram Hubertus, Dipl.-Phys.
(86) Internationale Anmeldenummer: DE0003523
(87) Internationale Veröffentlichungsnummer: WO01024331

(56) Entgegenhaltungen:
- DE-A- 4 109 957
- US-A- 4 369 525
- US-A- 4 884 279
- US-A- 5 850 409
- PATENT ABSTRACTS OF JAPAN vol. 013, no. 160 (E-744), 18. April 1989 (1989-04-18) & JP 63 314877 A (YOKOGAWA ELECTRIC CORP), 22. Dezember 1988 (1988-12-22)
- D.W. SMITH, T.G. HODGKINSON: "LASER LEVEL CONTROL FOR HIGH BIT RATE OPTICAL FIBRE SYSTEM", Proceedings of the International Symposium on Circuits and Systems, Houston, 28.-30. April 1980, New York, IEEE Vol. 1 Conf. 13, Seiten 926-930

## Beschreibung

Die Erfindung betrifft eine Regelvorrichtung für eine Laserdiode mit einer Vorspannungs-Gleichstromquelle, die mit der Laserdiode verbunden ist, so daß die Laserdiode von der Vorspannungs-Gleichstromquelle einen Vorspannungs-Gleichstrom empfangen kann; einem Modulator, wobei ein Signalstrom der Laserdiode mit Hilfe des Modulators einem Datensignal entsprechend moduliert werden kann, welches der Modulator empfängt; und einer Temperaturkompensationseinrichtung, die mit dem Modulator so verbunden werden kann, daß der Signalstrom in Abhängigkeit von Temperaturänderungen regelbar und/oder steuerbar ist.

Laserdioden werden für die schnelle Übertragung digitaler, optischer Signale insbesondere deshalb genutzt, weil sie eine schmale Spektralbreite und die Fähigkeit zur schnellen Modulation aufweisen. Bei derartigen Laserdioden treten im Betrieb Abweichungen von einer vorgegebenen Kennliniencharakteristik auf, die beispielsweise von dem Lebensalter der Laserdiode oder der Temperatur abhängen. In Abhängigkeit von der Anwendung der Laserdiode werden verschiedene Regelmechanismen genutzt, um die Abweichungen von der Kennlinie zu kompensieren.

Zu diesen Regelmechanismen gehört die Verwendung einer Temperaturkompensationseinrichtung. Eine derartige Regelung ist notwendig, da der Stromschwellwert Iₛ der Kennlinie einer Laserdiode, bei dem die Kennlinie aus einem Bereich des Vorspannungs-Gleichstroms (keine Lichtemission) in einen Bereich des Signalstroms (Bereich der Lichtemission) übergeht, temperaturabhängig ist. Mit Hilfe der Temperaturkompensationseinrichtung kann der Vorspannungs-Gleichstrom der Laserdiode so geregelt werden, daß die Laserdiode stets im Bereich des Signalstroms arbeitet. Nachteil dieser Regelungsart ist es, daß keine Regelung des modulierten Signalstroms erfolgt, so daß beispielsweise Kennlinienänderungen, insbesondere hinsichtlich der Steilheit in Folge der Alterung der Laserdiode oder aufgrund von Temperaturänderungen nicht ausgeglichen werden können. Der Einfluß solcher Kennlinienänderungen kann mit Hilfe einer Pilottonregeleinrichtung vermindert, vorzugsweise ausgeschlossen werden.

Eine Pilottonregeleinrichtung ist beispielsweise aus der Veröffentlichung von D. W. Smith und T. G. Hodgkinson mit dem Titel "Laserpegelsteuerung für optische Fasersysteme mit hoher Bitrate", Symposium, Houston, April 1980 bekannt. Es wird zwischen einer Pilottonregelung auf dem Hochpegel des Signalstroms der Laserdiode und einer Pilottonregelung auf dem Hoch- und dem Niedrigpegel des Signalstroms unterschieden. Grundsätzlich wird hierbei eine Pilottonfrequenz auf den Signalstrom (Pilottonregelung auf dem Hochpegel) oder auf den Signalstrom und den Gleichstrom (Pilottonregelung auf dem Hoch- und dem Niedrigpegel) aufmoduliert. Mit Hilfe einer Monitordiode wird ein Teil des abgestrahlten Lichts registriert. Der registrierte Teil des Lichts wird ausgewertet, um im Fall von Abweichungen hinsichtlich der mittleren Ausgangsleistung der Laserdiode und der Pilottonamplitude eine Nachregulierung auszuführen. Nachteil der Pilottonregelung auf dem Hoch- und dem Niedrigpegel ist es, daß bei hohen Datenraten wegen der Modulation des Signalstroms im Bereich des Schwellwertstroms Iₛ, in dem die Kennlinie der Laserdiode abknickt, Jitter begünstigt werden. Dieses kann mit Hilfe der Pilottonregelung auf dem Hochpegel des Signalstroms vermieden werden.

Aufgabe der vorliegenden Erfindung ist es, eine Regelvorrichtung für eine Laserdiode zu schaffen, mit der die Möglichkeiten zur Nutzung der verschiedenen Regelmechanismen verbessert werden.

Diese Aufgabe wird bei einer Regelvorrichtung nach dem Oberbegriff des Anspruchs 1 erfindungsgemäß dadurch gelöst, daß eine Pilottonregeleinrichtung zum Regeln des Signalstroms mit Hilfe einer auf den Signalstrom aufmodulierten Pilottonfrequenz und Schaltmittel vorgesehen sind, um die Regelvorrichtung zwischen einem Zustand, in welchem die Pilottonregeleinrichtung mit dem Modulator und der Vorspannungs-Gleichstromquelle so verbunden ist, daß der Signalstrom mit Hilfe der Pilottonregeleinrichtung regelbar ist, und einem anderen Zustand umschalten zu können, in welchem der Modulator mit der Temperaturkompensationseinrichtung so verbunden ist, daß der Signalstrom mittels der Temperaturkompensationseinrichtung regelbar und/oder steuerbar ist.

Der wesentliche Vorteil, welcher mit der Erfindung gegenüber dem Stand der Technik erreicht ist, besteht darin, daß mit Hilfe einer einzelnen Regelvorrichtung die Nutzung von zwei der oben beschriebenen, unterschiedlichen Regelmechanismen für Laserdioden nutzbar ist. In Abhängigkeit von dem Anwendungsfall kann somit der für diesen Anwendungsfall günstige Regelmechanismus ausgewählt und genutzt werden.

Bei einer zweckmäßigen Weiterbildung der Erfindung umfaßt die Pilottonregeleinrichtung weitere Schaltmittel, so daß die Pilottonregeleinrichtung zwischen einem Zustand, in welchem auf einem Hochpegel des Signalstroms geregelt werden kann, und einem anderen Zustand umschaltbar ist, in welchem auf einem Niedrigpegel und dem Hochpegel des Signalstroms geregelt werden kann. Hierdurch kann bei der Nutzung einer einzigen Regelvorrichtung zwischen drei möglichen Regelmechanismen ausgewählt werden.

Eine vorteilhafte Ausgestaltung der Erfindung sieht vor, daß die Pilottonregeleinrichtung die folgenden Komponenten umfaßt: eine Monitordiode zum Empfangen eines Monitorsignals; einen ersten Integrator, der mit der Monitordiode und der Vorspannungs-Gleichstromquelle verbunden ist; eine Frequenzmischeinrichtung, die an eine Verbindung zwischen der Monitordiode und dem ersten Integrator und an eine Oszillatoreinrichtung zur Erzeugung der Pilottonfrequenz gekoppelt ist; eine Aufbereitungseinrichtung zur Aufbereitung der Pilottonfrequenz, die die Aufbereitungseinrichtung von der Oszillatoreinrichtung empfangen kann, wobei ein Ausgang der Aufbereitungseinrichtung mit dem Modulator und ein anderer Ausgang der Aufbereitungseinrichtung mit der Vorspannungs-Gleichstromquelle verbunden werden können; und einen mit der Frequenzmischeinrichtung verbundenen zweiten Integrator, dessen Ausgang mit dem Modulator verbunden werden kann. Hierdurch ist eine mit einfachen schaltungstechnischen Mitteln ausbildbare Ausführungsform der Regelvorrichtung ermöglicht.

Zweckmäßig kann vorgesehen sein, daß ein Eingang des zweiten Integrators mit den weiteren Schaltmitteln verbunden ist, und daß der Eingang mit Hilfe der weiteren Schaltmittel in Abhängigkeit von einem Schaltzustand der weiteren Schaltmittel an eine Referenzspannungseinrichtung und ein Erdpotential gekoppelt werden kann, um die Pilottonregeleinrichtung in den einen bzw. den anderen Zustand versetzen zu können. Hierdurch ist mit einfachen Bauelementen eine Möglichkeit geschaffen, die Pilottonregeleinrichtung zwischen zwei Zuständen umzuschalten.

Bei einer Weiterbildung der Erfindung sind die Schaltmittel und/oder die weiteren Schaltmittel als programmierbare Schalter ausgebildet, wodurch eine Möglichkeit für eine externe Steuerung der Schaltmittel und der weiteren Schaltmittel geschaffen ist.

Vorteilhaft sind die Schaltmittel und/oder die weiteren Schaltmittel mit Hilfe eines Hoch- bzw. eines Niedrigpegels eines Schaltsignals steuerbar, wodurch die Steuerung der Schaltmittel und der weiteren Schaltmittel mit Hilfe einfacher schaltungstechnischer Komponenten möglich ist.

Eine Weiterbildung der Erfindung sieht vor, daß die Schaltmittel einen ersten Schalter der zwischen dem Ausgang des zweiten Integrators und dem Modulator gekoppelt ist, einen zweiten Schalter, der zwischen einem Ausgang der Aufbereitungseinrichtung und dem Modulator gekoppelt ist und einen dritten Schalter umfassen, der zwischen einem anderen Ausgang der Aufbereitungseinrichtung und der Vorspannungs-Gleichstromquelle gekoppelt ist. Hierdurch können die Komponenten der Pilottonregeleinrichtung im wesentlichen vollständig von der Regelvorrichtung getrennt werden, so daß bei der Nutzung einer Temperaturkompensation störende Einflüsse aus den Komponenten der Pilottonregeleinrichtung vermindert werden.

Bei einer zweckmäßigen Ausgestaltung der Erfindung ist die Laserdiode durch eine Anordnung mehrerer Laserdioden ersetzt, wodurch die Regelvorrichtung beispielsweise für Laserdiodenanordnungen zur Übertragung mehrerer paralleler, optischer Signale nutzbar ist.

Die Erfindung wird im Folgenden anhand eines Ausführungsbeispiels unter Bezugnahme auf eine Zeichnung näher erläutert.

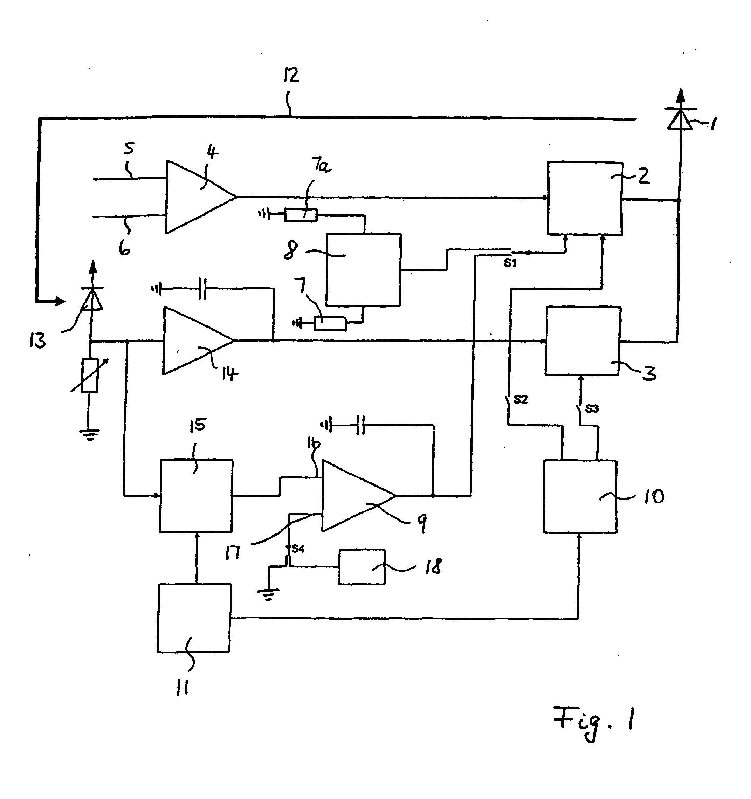

Gemäß Figur 1 ist eine Laserdiode 1 an einen Modulator 2 und eine Vorspannungs-Gleichstromquelle 3 angeschlossen. Mit Hilfe der Vorspannungs-Gleichstromquelle 3 wird ein Vorspannungs-Gleichstrom auf die Laserdiode 1 gegeben, so daß die Laserdiode 1 mit Hilfe eines Modulationsstroms, der von dem Modulator 2 erzeugt wird, in einem Kennlinienbereich betrieben werden kann, der bei einem Schwellwertstrom Iₛ beginnt. Der Modulationsstrom wird in dem Modulator 2 einem Datensignal entsprechend erzeugt, welches der Modulator 2 von einer Eingangsstufe 4 empfängt, die einen invertierenden Eingang 5 und einen nicht-invertierenden Eingang 6 aufweist. Der Modulator 2 ist beispielsweise mit Hilfe eines externen Widerstands 7 in der Amplitude einstellbar.

Mit Hilfe der in Figur 1 dargestellten Regelvorrichtung können drei verschiedene Regelmechanismen auf die Laserdiode 1 angewendet werden, wobei Schalter S1 bis S4 genutzt werden, um einen der verschiedenen Regelmechanismus so auszuwählen, daß dieser bei einer Steuerung der Laserdiode genutzt wird.

In einem ersten Anwendungsfall ist der Modulator 2 mit Hilfe des Schalters S1 mit einer Temperaturkompensationseinrichtung 8 verbunden. Die Schalter S2 und S3 sind in diesem Fall geöffnet. Mit Hilfe der Temperaturkompensationseinrichtung 8 können Verschiebungen in der Kennlinie der Laserdiode 1, beispielsweise hinsichtlich der Steilheit, über den Modulationsstrom kompensiert werden. Hierzu weist die Temperaturkompensationseinrichtung 8 insbesondere einen Temperaturfühler auf. Mit Hilfe eines weiteren externen Widerstands 7a kann ein Temperaturkoeffizient des Modulationsstroms eingestellt werden.

In einem zweiten Anwendungsfall ist der Modulator 2 mit Hilfe des Schalters S1, der gegenüber dem ersten Anwendungsfall umgeschaltet ist, mit einem ersten Integrator 9 verbunden. Die Schalter S2 und S3 sind geschlossen, so daß der Modulator 2 und die Vorspannungs-Gleichstromquelle 3 jeweils mit einer Aufbereitungseinrichtung 10 verbunden sind. Mit Hilfe der Aufbereitungseinrichtung 10 wird eine von einem lokalen Oszillator 11 erzeugte Pilottonfrequenz so aufbereitet, daß sie auf den Vorspannungs-Gleichstrom und den Modulationsstrom aufmoduliert werden kann.

Ein von der Laserdiode 1 ausgesendetes, optisches Signal wird über eine optische Rückkopplung 12 teilweise auf eine Monitordiode 13 übertragen und in ein elektrisches Monitorsignal umgewandelt. Das Monitorsignal wird auf einen zweiten Integrator 14 und einen Frequenzmischer 15 übertragen. Der zweiten Integrator 14 verstärkt das Monitorsignal und führt der Vorspannungs-Gleichstromquelle 3 ein Regelsignal zu, so daß der an die Laserdiode 1 zu übertragende Vorspannungs-Gleichstrom geregelt wird. Eine untere Grenzfrequenz dieses Regelkreises muß kleiner als die Pilottonfrequenz sein, die beispielsweise 3 kHz beträgt und somit wesentlich geringer als übliche Modulationsfrequenzen des Modulationsstroms ist, die beispielsweise 100 kHz bis über 1 GHz betragen können.

In dem Frequenzmischer 15 werden die mit Hilfe der Monitordiode 13 empfangene Pilottonfrequenz und die von dem lokalen Oszillator 11 erzeugt Pilottonfrequenz gemischt, beispielsweise miteinander multipliziert, so daß Frequenzanteile, die von der Pilottonfrequenz abweichen, sich nicht auswirken (Synchrongleichrichter). Der Ausgang des Frequenzmischers 15 wird einem Eingang 16 des ersten Integrators 9 zugeführt. Ein anderer Eingang 17 des ersten Integrators 9 ist über den Schalter S4 mit einem Erdpotential verbunden. Die Regelung ist eingeschwungen, wenn der Ausgang des Frequenzmischers 15 Null ist, so daß von dem ersten Integrator 9 über den Schalter S1 kein Regelsignal an den Modulator 2 ausgegeben wird. Dies bedeutet, daß die mit Hilfe der Monitordiode 13 registrierte Pilottonamplitude auf dem Hoch- und dem Niedrigpegel gleich groß ist. Bei diesem Anwendungsfall handelt es sich um eine Pilottonregelung auf einen Hoch- und einen Niedrigpegel des Modulationsstroms.

In einem dritten Anwendungsfall ist der Schalter S4 im Vergleich zu dem zweiten Anwendungsfall umgeschaltet, so daß der weitere Eingang 17 des ersten Integrators 9 mit einer Referenzspannungsquelle 18 verbunden ist. Mit Hilfe der Referenzspannungsquelle 18 kann von außen ein Referenzsignal auf den ersten Integrator 9 gegeben werden. Es handelt sich hierbei um eine Pilottonregelung auf dem Hochpegel des Modulationsstroms. Auch beim dritten Anwendungsfall muß die untere Grenzfrequenz des Regelkreises kleiner als die Pilottonfrequenz sein.

Die in Figur 1 dargestellt Regelvorrichtung kann als eine integrierte Schaltung ausgebildet sein, die mit einer Laserdiode 1 oder einer Anordnung mehrerer Laserdioden verbunden ist. In Abhängigkeit von der Anwendung, für welche die Laserdiode 1 oder die Laserdiodenanordnung genutzt werden soll, kann bei der Programmierung der integrierten Schaltung einer der oben beschriebenen Regelmechanismen mit Hilfe des Setzens der Schalter S1 bis S4 ausgewählt werden. Die integrierte Schaltung ist auf diese Weise an verschiedene Anwendungsfälle anpaßbar.

Bei einer elektronischen Implementierung der Schalter S1 bis S4 kann vorgesehen sein, daß die Schalter S1 bis S4 mit Hilfe eines jeweiligen PIN's von außen dadurch gesteuert werden, daß ein Hoch- oder ein Niedrigpegel eines Steuersignals angelegt wird. Hierdurch ist ein sehr kompakter Aufbau der Regelvorrichtung möglich, der eine mit wenig Aufwand realisierbare, externe Schaltung benötigt.

Ein wesentlicher Vorteil der beschriebenen Regelvorrichtung besteht darin, daß mehrere Komponenten der Regelvorrichtung bei der Nutzung verschiedener Regelmechanismen genutzt werden können. So werden die Regelung auf dem Hochpegel des Modulationsstroms und die Regelung auf dem Hoch- und dem Niedrigpegel des Modulationsstroms im wesentlichen mit denselben Komponenten realisiert, wobei lediglich der Schalter S4 den weiteren Eingang 17 des ersten Integrator 9 entweder mit einem Erdpotential oder mit der Referenzspannungsquelle 18 verbindet. Hierdurch ist die Anzahl der Bauelemente minimiert, die zur Realisierung der verschiedenen Regelmechanismen benötigt werden.

## Patentansprüche

1. Regelvorrichtung für eine Laserdiode (1) mit
- einer Vorspannungs-Gleichstromquelle (3), die mit der Laserdiode verbunden ist, so daß die Laserdiode (1) von der Vorspannungs-Gleichstromquelle (3) einen Vorspannungs-Gleichstrom empfangen kann;
- einem Modulator (2), wobei ein Signalstrom der Laserdiode (1) mit Hilfe des Modulators (2) einem Datensignal entsprechend moduliert werden kann, welches der Modulator (2) empfängt; und
- einer Temperaturkompensationseinrichtung (8), die mit dem Modulator (2) so verbunden werden kann, daß der Signalstrom in Abhängigkeit von Temperaturänderungen regelbar unsd/oder steuerbar ist;
**gekennzeichnet durch**
- eine Pilottonregeleinrichtung zum Regeln des Signalstroms mit Hilfe einer auf den Signalstrom aufmodulierten Pilottonfrequenz; und
- Schaltmittel (S1, S2, S3), um die Regelvorrichtung zwischen einem Zustand, in welchem die Pilottonregeleinrichtung mit dem Modulator (2) und der Vorspannungs-Gleichstromquelle (3) so verbunden ist, daß der Signalstrom mit Hilfe der Pilottonregeleinrichtung regelbar ist, und einem anderen Zustand umschalten zu können, in welchem der Modulator (2) mit der Temperaturkompensationseinrichtung (8) so verbunden ist, daß der Signalstrom mittels der Temperaturkompensationseinrichtung (8) regelbar und/oder steuerbar ist.

2. Regelvorrichtung nach Anspruch 1, **dadurch gekennzeichnet, daß** die Pilottonregeleinrichtung weitere Schaltmittel (S4) umfaßt, so daß die Pilottonregeleinrichtung zwischen einem Zustand, in welchem auf einem Hochpegel des Signalstroms geregelt werden kann, und einem anderen Zustand umschaltbar ist, in welchem auf einem Niedrigpegel und dem Hochpegel des Signalstroms geregelt werden kann.

3. Regelvorrichtung nach Anspruch 1 oder 2, die Pilottonregeleinrichtung umfassend:
- eine Monitordiode (13) zum Empfangen eines Monitorsignals;
- einen ersten Integrator (14), der mit der Monitordiode (13) und der Vorspannungs-Gleichstromquelle (3) verbunden ist;
- eine Frequenzmischeinrichtung (15), die an eine Verbindung zwischen der Monitordiode (13) und dem ersten Integrator (14) und an eine Oszillatoreinrichtung (11) zur Erzeugung der Pilottonfrequenz gekoppelt ist;
- eine Aufbereitungseinrichtung (10) zur Aufbereitung der Pilottonfrequenz, die die Aufbereitungseinrichtung (10) von der Oszillatoreinrichtung (11) empfangen kann, wobei ein Ausgang der Aufbereitungseinrichtung (10) mit dem Modulator (2) und ein anderer Ausgang der Aufbereitungseinrichtung (10) mit der Vorspannungs-Gleichstromquelle (3) verbunden werden können; und
- einen mit der Frequenzmischeinrichtung (15) verbundenen zweiten Integrator (9), dessen Ausgang mit dem Modulator (2) verbunden werden kann.

4. Regelvorrichtung nach Anspruch 3, **dadurch ge-kennzeichnet, daß** ein Eingang (17) des zweiten Integrators (9) mit den weiteren Schaltmitteln (S4) verbunden ist, und daß der Eingang (17) mit Hilfe der weiteren Schaltmittel (S4) in Abhängigkeit von einem Schaltzustand der weiteren Schaltmittel (S4) an eine Referenzspannungseinrichtung (18) und ein Erdpotential gekoppelt werden kann, um die Pilottonregeleinrichtung in den einen bzw. den anderen Zustand versetzen zu können.

5. Regelvorrichtung nach einem der vorhergehenden Ansprüche, **dadurch gekennzeichnet, daß** die Schaltmittel (S1, S2, S3) und/oder die weiteren Schaltmittel (S4) als programmierbare Schalter ausgebildet sind.

6. Regelvorrichtung nach einem der vorhergehenden Ansprüche, **dadurch gekennzeichnet, daß** die Schaltmittel (S1, S2, S3) und/oder die weiteren Schaltmittel (S4) mit Hilfe eines Hoch- bzw. eines Niedrigpegels eines Schaltsignals steuerbar sind.

7. Regelvorrichtung nach einem der Ansprüche 3 bis 6, d a-durch gekennzeichnet, daß die Schaltmittel (S1, S2, S3) einen ersten Schalter (S1), der zwischen dem Ausgang des zweiten Integrators (9) und dem Modulator (2) gekoppelt ist, einen zweiten Schalter (S2), der zwischen dem einen Ausgang der Aufbereitungseinrichtung (10) und dem Modulator (2) gekoppelt ist, und einen dritten Schalter (S3) umfassen, der zwischen dem anderen Ausgang der Aufbereitungseinrichtung (10) und der Vorspannungs-Gleichstromquelle (3) gekoppelt ist.

8. Regelvorrichtung nach einem der vorhergehenden Ansprüche, **dadurch gekennzeichnet, daß** die Laserdiode (1) durch eine Anordnung mehrerer Laserdiode ersetzt ist.

## Claims

1. Control device for a laser diode (1), having
- a direct bias current source (3) which is connected to the laser diode so that the laser diode (1) can receive a direct bias current from the direct bias current source (3);
- a modulator (2), it being possible for a signal current from the laser diode (1) to be modulated, with the aid of the modulator (2), in accordance with a data signal which the modulator (2) receives; and
- a temperature compensation device (8) which can be connected to the modulator (2) in such a way that the signal current can be regulated and/or controlled as a function of temperature changes;
**characterized by**
- a pilot tone control device for controlling the signal current with the aid of a pilot tone frequency modulated onto the signal current; and
- switching means (S1, S2, S3), in order to be able to change over the control device between a state in which the pilot tone control device is connected to the modulator (2) and the direct bias current source (3) in such a way that the signal current can be regulated with the aid of the pilot tone control device, and another state in which the modulator (2) is connected to the temperature compensation device (8) in such a way that the signal current can be regulated and/or controlled by means of the temperature compensation device (8).

2. Control device according to Claim 1, **characterized in that** the pilot tone control device comprises further switching means (S4), so that the pilot tone control device can be changed over between a state in which it is possible to control at a high level of the signal current and another state in which it is possible to control at a low level and the high level of the signal current.

3. Control device according to Claim 1 or 2, the pilot tone control device comprising:
- a monitor diode (13) for receiving a monitor signal;
- a first integrator (14), which is connected to the monitor diode (13) and the direct bias current source (3);
- a frequency mixing device (15), which is coupled to a connection between the monitor diode (13) and the first integrator (14) and to an oscillator device (11) for generating the pilot tone frequency;
- a conditioning device (10) for conditioning the pilot tone frequency, which the conditioning device (10) can receive from the oscillator device (11), it being possible for one output of the conditioning device (10) to be connected to the modulator (2) and another output of the conditioning device (10) to be connected to the direct bias current source (3); and
- a second integrator (9), which is connected to the frequency mixing device (15) and whose output can be connected to the modulator (2).

4. Control device according to Claim 3, **characterized in that** one input (17) of the second integrator (9) is connected to the further switching means (S4), and **in that** the input (17) can be coupled to a reference voltage device (18) and an earth potential with the aid of the further switching means (S4), as a function of a switching state of the further switching means (S4), in order to be able to set the pilot tone control device into one or the other state.

5. Control device according to one of the preceding claims, **characterized in that** the switching means (S1, S2, S3) and/or the further switching means (S4) are constructed as programmable switches.

6. Control device according to one of the preceding claims, **characterized in that** the switching means (S1, S2, S3) and/or the further switching means (S4) can be controlled with the aid of a high or low level of a switching signal.

7. Control device according to one of Claims 3 to 6, **characterized in that** the switching means (S1, S2, S3) comprise a first switch (S1), which is coupled between the output of the second integrator (9) and the modulator (2), a second switch (S2), which is coupled between the one output of the conditioning device (10) and the modulator (2), and a third switch (S3), which is coupled between the other output of the conditioning device (10) and the direct bias current source (3).

8. Control device according to one of the preceding claims, **characterized in that** the laser diode (1) is replaced by an arrangement of a plurality of laser diodes.

## Revendications

1. Dispositif de régulation d'une diode (1) laser comprenant
- une source (3) de tension continue de polarisation qui est reliée à la diode laser, de sorte que la diode (1) laser peut recevoir un courant continu de polarisation de la source (3) de tension continu de polarisation ;
- un modulateur (2), un courant de signal de la diode (1) laser pouvant être modulé à l'aide du modulateur (2) en fonction d'un signal de données que le modulateur (2) reçoit ; et
- un dispositif (8) de compensation de la température qui peut être relié au modulateur (2) de façon à ce que le courant de signal puisse être réglé et/ou commandé en fonction des variations de la température ;
**caractérisé par**
- un dispositif de régulation du signal pilote destiné à régler le courant de signal à l'aide d'une fréquence de signal pilote modulée sur le courant de signal ; et
- des moyens (S1, S2, S3) de commutation destinés à permettre de commuter le dispositif de régulation entre un état dans lequel le dispositif de régulation du signal pilote est relié au modulateur (2) et à la source (3) de courant continu de polarisation, de façon à ce que le courant de signal puisse être réglé à l'aide du dispositif de régulation du signal pilote, et un autre état dans lequel le modulateur (2) est relié au dispositif (8) de compensation de la température, de façon à ce que le courant de signal puisse être réglé et/ou commandé au moyen du dispositif (8) de compensation de la température.

2. Dispositif de régulation suivant la revendication 1, **caractérisé en ce que** le dispositif de régulation du signal pilote comprend des moyens (S4) supplémentaires de commutation, de sorte que le dispositif de régulation du signal pilote puisse être commuté entre un état dans lequel il peut être réglé sur un niveau haut du courant de signal et un autre état dans lequel il peut être réglé sur un niveau bas et sur le niveau haut du courant de signal.

3. Dispositif de régulation suivant la revendication 1 ou 2, **caractérisé en ce que** le dispositif de régulation du signal pilote comprend :
- une diode (13) de moniteur de réception d'un signal de moniteur ;
- un premier intégrateur (14) qui est relié à la diode (13) de moniteur et à la source (3) de tension continue de polarisation ;
- un dispositif (15) de mélange de fréquences, qui est couplé à une liaison entre la diode (13) de moniteur et le premier intégrateur (14) et à un dispositif (11) d'oscillateur pour produire la fréquence de signal pilote ;
- un dispositif (10) de traitement destiné à traiter la fréquence de signal pilote, que le dispositif (10) de traitement peut recevoir du dispositif (11) d'oscillateur, une sortie du dispositif (10) de traitement pouvant être reliée au modulateur (2) et une autre sortie du dispositif (10) de traitement pouvant être reliée à la source (3) de courant continu de polarisation ; et
- un deuxième intégrateur (9) qui est relié au dispositif (15) de mélange de fréquences et dont la sortie peut être reliée au modulateur (2).

4. Dispositif de régulation suivant la revendication 3, **caractérisé en ce qu'**une entrée (17) du deuxième intégrateur (9) est reliée aux moyens (S4) supplémentaires de commutation et **en ce que** l'entrée (17) peut être couplée à l'aide de moyens (S4) supplémentaires de commutation en fonction d'un état de commutation de moyens (S4) supplémentaires de commutation à un dispositif (18) de tension de référence et à un potentiel de terre afin de pouvoir mettre le dispositif de régulation du signal pilote dans l'un ou l'autre des états.

5. Dispositif de régulation suivant l'une des revendications précédentes, **caractérisé en ce que** les moyens (S1, S2, S3) de commutation et/ou les moyens (S4) supplémentaires de commutation sont constitués sous la forme d'interrupteurs pouvant être programmés.

6. Dispositif de régulation suivant l'une des revendications précédentes, **caractérisé en ce que** les moyens (S1, S2, S3) de commutation et/ou les moyens (S4) supplémentaires de commutation peuvent être commandés à l'aide d'un niveau haut ou d'un niveau bas d'un signal de commutation.

7. Dispositif de régulation suivant l'une des revendications3 à 6, **caractérisé en ce que** les moyens (S1, S2, S3) de commutation comprennent un premier interrupteur (S1) qui est couplé entre la sortie du deuxième intégrateur (9) et le modulateur (2), un deuxième interrupteur (S2) qui est couplé entre l'une des sorties du dispositif (10) de traitement et le modulateur (2) et un troisième interrupteur (S3) qui est couplé entre l'autre sortie du dispositif (10) de traitement et la source (3) de courant continu de polarisation.

8. Dispositif de régulation suivant l'une des revendications précédentes, **caractérisé en ce que** la diode (1) laser est remplacée par un agencement de plusieurs diodes laser.
